# EUROPEAN PATENT APPLICATION

(11) **EP 4 283 683 A1**
(43) Date of publication of application: **29.11.2023**
(21) Application number: 23162851.2
(22) Date of filing: 20.03.2023
(51) Int. Cl.: H01L 29/51, H01L 21/28, H01L 29/78, H01L 21/336

(54) **SEMICONDUCTOR DEVICES AND METHODS FOR FABRICATING THE SAME**

(30) Priority: 24.05.2022 KR 20220063238
(71) Applicant: Samsung Electronics Co., Ltd., Suwon-si, Gyeonggi-do 16677 (KR)
(72) Inventor: LEE, Ki Heun, Suwon-si (KR); KIM, Yong Seok, Suwon-si (KR); KIM, Hyun Cheol, Suwon-si (KR); HA, Dae Won, Suwon-si (KR)
(74) Representative: Marks & Clerk LLP

(57) **Abstract**

A semiconductor device including a ferroelectric field effect transistor (FeFET) and a method for fabricating the same are provided. The semiconductor device includes a substrate (100), a gate electrode film (140) including a metal element, on the substrate (100), a gate insulating film (120) including a ferroelectric material between the substrate (100) and the gate electrode film (140), and a buffer oxide film (135) including an oxide of a semiconductor material between the gate insulating film (120) and the gate electrode film (140), the buffer oxide film (135) being in contact with the gate insulating film (120).

## Description

### BACKGROUND

The present disclosure relates to semiconductor devices and methods for fabricating the same. Ferroelectrics are materials having ferroelectricity in which internal electric dipole moments are aligned and maintain spontaneous polarization even when an external electric field is not applied. Also, the polarization of ferroelectrics may be changed by applying an external electric field above a coercive field, and the state thereof may be read electrically through changes in materials such as adjacent metals and semiconductors. Therefore, research for improving the performance by applying such ferroelectricity to the semiconductor devices is being conducted.

In particular, as the ferroelectricity of hafnium-based oxides is researched, a ferroelectric field effect transistor (FeFET) that utilizes hafnium-based oxides may be developed. Since the hafnium-based oxides are friendly to semiconductor processes and may maintain ferroelectricity even in very thin films, they are expected to contribute to the miniaturization of the semiconductor devices.

### SUMMARY

Aspects of the present inventive concept provide a semiconductor device including a ferroelectric field effect transistor (FeFET) having improved characteristics.

Aspects of the present inventive concept also provide a method for fabricating a semiconductor device including a ferroelectric field effect transistor (FeFET) having improved characteristics.

However, aspects of the present inventive concept are not restricted to the one set forth herein. The above and other aspects of the present inventive concept will become more apparent to one of ordinary skill in the art to which the present inventive concept pertains by referencing the detailed description of the present inventive concept given below.

According to aspects of the present inventive concept, there is provided a semiconductor device comprising a substrate, a gate electrode film including a metal element, on the substrate, a gate insulating film including a ferroelectric material between the substrate and the gate electrode film, and a buffer oxide film including an oxide of a semiconductor material between the gate insulating film and the gate electrode film, the buffer oxide film being in contact with the gate insulating film.

According to aspects of the present inventive concept, there is provided a semiconductor device comprising a substrate including a first semiconductor material, a gate electrode film including a metal element, on the substrate, a gate insulating film including a ferroelectric material, between the substrate and the gate electrode film, an interface film including an oxide of the first semiconductor material, between the gate insulating film and the substrate, and a buffer oxide film including an oxide of a second semiconductor material, between the gate insulating film and the gate electrode film, wherein a thickness of the interface film is smaller than a thickness of the buffer oxide film.

According to aspects of the present inventive concept, there is provided a semiconductor device comprising a substrate including a first semiconductor material, a gate electrode film including a metal element, on the substrate, a gate insulating film including a ferroelectric material, between the substrate and the gate electrode film, a buffer film including a second semiconductor material, between the gate insulating film and the gate electrode film, and a buffer oxide film including an oxide of the second semiconductor material, between the gate insulating film and the buffer film.

According to aspects of the present inventive concept, there is provided a semiconductor device comprising a substrate including silicon (Si), a gate electrode film including a metal element, on the substrate, a gate insulating film including a hafnium-based oxide having ferroelectricity, between the substrate and the gate electrode film, a buffer film including Si, between the gate insulating film and the gate electrode film, and a buffer oxide film including an Si oxide film, between the gate insulating film and the buffer film.

According to aspects of the present inventive concept, there is provided a method for fabricating a semiconductor device, the method comprising providing a substrate including a first semiconductor material, forming a gate insulating film including a ferroelectric material, on the substrate, forming a buffer film including a second semiconductor material, on the gate insulating film, forming a gate electrode film including a metal element, on the buffer film, and performing an annealing process.

At least some of the above and other features of the invention are set out in the claims.

### BRIEF DESCRIPTION OF THE DRAWINGS

The above and other aspects and features of the present inventive concept will become more apparent by describing in detail example embodiments thereof with reference to the attached drawings, in which:
FIG. 1 is an example cross-sectional view for explaining a semiconductor device according to some embodiments.
FIG. 2 is an enlarged view for explaining a region R1 of FIG. 1.
FIG. 3 is an example cross-sectional view for explaining a semiconductor device according to some embodiments.
FIG. 4 is an enlarged view for explaining a region R1 of FIG. 3.
FIG. 5 is an example cross-sectional view for explaining a semiconductor device according to some embodiments.
FIG. 6 is an example layout diagram for explaining a semiconductor device according to some embodiments.
FIGS. 7 and 8 are various schematic cross-sectional views taken along A-A of FIG. 6.
FIG. 9 is an example layout diagram for explaining a semiconductor device according to some embodiments.
FIG. 10 is a schematic cross-sectional view taken along B-B of FIG. 9.
FIG. 11 is an example layout diagram for explaining a semiconductor device according to some embodiments.
FIG. 12 is a schematic cross-sectional view taken along C-C of FIG. 11.
FIG. 13 is an enlarged view for explaining a region R2 of FIG. 12.
FIG. 14 is an example perspective view for explaining a semiconductor device according to some embodiments.
FIG. 15 is an enlarged view for explaining a region R3 of FIG. 14.
FIGS. 16 to 20 are intermediate process diagrams for explaining the method for fabricating the semiconductor device according to some embodiments.
FIGS. 21 and 22 are intermediate step diagrams for describing a method for fabricating the semiconductor device according to some embodiments.

### DETAILED DESCRIPTION

In the present specification, although terms such as first and second are used to describe various elements or components, it goes without saying that these elements or components are not limited by these terms. These terms are only used to distinguish a single element or component from other elements or components. Therefore, it goes without saying that a first element or component referred to below may be a second element or component within the scope of the present inventive concept.

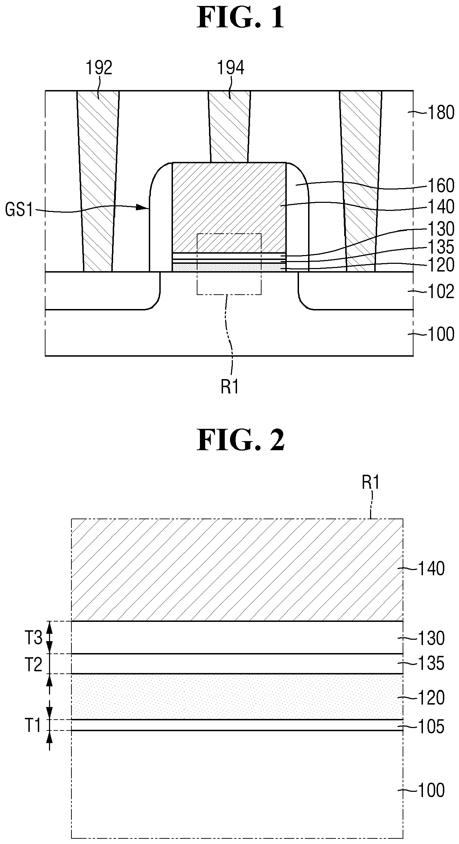

A semiconductor device according to example embodiments will be described below referring to FIGS. 1 to 15.

FIG. 1 is an example cross-sectional view for explaining a semiconductor device according to some embodiments. FIG. 2 is an enlarged view for explaining a region R1 of FIG. 1.

Referring to FIGS. 1 and 2, a semiconductor device according to some embodiments includes a substrate 100, a first source/drain region 102, a first gate structure GS1, a first interlayer insulating film 180, a source/drain contact 192, and a gate contact 194.

The substrate 100 may include a first semiconductor material. The substrate 100 may include, for example, silicon or germanium which is an elemental semiconductor material. Alternatively, the first semiconductor material may include a group IV-IV compound semiconductor or a group III-V compound semiconductor. The group IV-IV compound semiconductor may include, for example, a binary compound or a ternary compound including at least two or more of carbon (C), silicon (Si), germanium (Ge), and tin (Sn), or a compound obtained by doping these elements with a group IV element. The group II I-V compound semiconductor may be, for example, at least one of a binary compound, a ternary compound or a quaternary compound formed by combining at least one of aluminum (Al), gallium (Ga), or indium (In) as a group III element with one of phosphorus (P), arsenic (As), or antimony (Sb) as a group V element.

For example, substrate 100 may be bulk silicon or silicon-on-insulator (SOI). Alternatively, the substrate 100 may be an epitaxial layer formed on a base substrate. For convenience of explanation, the substrate 100 may be described as a silicon substrate herein.

In some embodiments, substrate 100 may include the first semiconductor material doped with an impurity element of a first conductivity type. For example, if the semiconductor device according to some embodiments is an NFET, the substrate 100 may include silicon (Si) doped with p-type impurities (e.g., boron (B), aluminum (Al), indium (In), gallium (Ga), etc.). Alternatively, for example, if the semiconductor device according to some embodiments is a PFET, the substrate 100 may include silicon (Si) doped with n-type impurities (e.g., phosphorous (P) or arsenic (As), etc.).

A first gate structure GS1 may be formed on the substrate 100. In some embodiments, the first gate structure GS1 may include a gate insulating film 120, a buffer oxide film 135, a buffer film 130, and a gate electrode film 140 that are sequentially stacked on the substrate 100.

The gate insulating film 120 may be stacked on the substrate 100. Also, the gate insulating film 120 may be interposed between the substrate 100 and the gate electrode film 140. The gate insulating film 120 may include a ferroelectric material having hysteresis characteristics. For example, the gate insulating film 120 may include at least one of hafnium oxide, zirconium oxide, yttrium-doped zirconium oxide, yttrium-doped hafnium oxide, magnesium-doped zirconium oxide, magnesium-doped hafnium oxide, silicon-doped hafnium oxide, silicon-doped zirconium oxide, barium-doped titanium oxide, or combinations thereof.

In some embodiments, the gate insulating film 120 may include a hafnium-based oxide having ferroelectricity. For example, the gate insulating film 120 may include hafnium oxide (HfO₂) in which at least one element of silicon (Si), zirconium (Zr), yttrium (Y), strontium (Sr), lanthanum (La), gadolinium (Gd), and aluminum (Al) is doped. Such a hafnium-based oxide may exhibit ferroelectricity by having an orthorhombic phase (O-phase).

In some embodiments, an interface film 105 may form between the substrate 100 and the gate insulating film 120, as shown in FIG. 2. The interface film 105 may include an oxide of the first semiconductor material of the substrate 100. For example, the interface film 105 may be an oxide film formed by oxidizing a surface (e.g., an upper side) of the substrate 100 adjacent to the gate insulating film 120. As an example, if the substrate 100 includes silicon (Si), the interface film 105 may include a silicon oxide film.

In some embodiments, the interface film 105 may come into contact with the gate insulating film 120. That is, the interface film 105 may form directly under the gate insulating film 120, and the substrate 100 may be formed directly under the interface film 105.

In some other embodiments, the interface film 105 may be not present between the substrate 100 and the gate insulating film 120. Here, the meaning of absence of the interface film 105 includes not only a case where the interface film 105 does not exist at all between the substrate 100 and the gate insulating film 120, but also a case where the interface film 105 exists very slightly at a thickness below the limit of measurement using transmission electron microscope (TEM) image analysis or the like.

A thickness T1 of the interface film 105 may be smaller than about 1 nanometer (nm). Preferably, the thickness T1 of the interface film 105 may be about 5 angstroms (Å) or less. Within the above range, the characteristics of the ferroelectric field effect transistor (FeFET) including the gate insulating film 120 may be improved. For example, the thickness T1 of the interface film 105 may be between about 0.01 Å and about 5 Å. More preferably, the thickness T1 of the interface film 105 may be about 1 Å or less.

The buffer film 130 may be stacked on the gate insulating film 120. Also, the buffer film 130 may be interposed between the gate insulating film 120 and the gate electrode film 140. The buffer film 130 may include a second semiconductor material. The second semiconductor material may include, for example, silicon (Si) or germanium (Ge) which is the elemental semiconductor material. Alternatively, the first semiconductor material may include a group IV-IV compound semiconductor or a group III-V compound semiconductor. The group IV-IV compound semiconductor may include, for example, a binary compound or a ternary compound including at least two or more of carbon (C), silicon (Si), germanium (Ge), and tin (Sn), or a compound obtained by doping these elements with a group IV element. The group III-V compound semiconductor may be, for example, at least one of a binary compound, a ternary compound, or a quaternary compound formed by combining at least one of aluminum (Al), gallium (Ga), or indium (In) as a group III element with one of phosphorus (P), arsenic (As), or antimony (Sb) as a group V element. As an example, the buffer film 130 may include polysilicon or amorphous silicon.

A thickness T3 of the buffer film 130 may be smaller than about 10 nm. The buffer film 130 may impede/prevent deterioration of the characteristics of the semiconductor device within the above range. Preferably, the thickness T3 of the buffer film 130 may be about 5 nm or less. For example, the thickness T3 of the buffer film 130 may be between approximately 0.01 nm and approximately 5 nm. More preferably, the thickness T3 of the buffer film 130 may be about 1 nm or less. According to some embodiments, the thickness T3 of the buffer film 130 may be thicker than the thickness T2 of the buffer oxide film 135.

In some embodiments, the first semiconductor material and the second semiconductor material may be the same as each other. As an example, the substrate 100 and the buffer film 130 may each include silicon (Si).

In some embodiments, the coefficient of thermal expansion (CTE) of the buffer film 130 may be smaller than the coefficient of thermal expansion (CTE) of the gate insulating film 120. For example, if the gate insulating film 120 includes hafnium-based oxide, the buffer film 130 may include silicon (Si). The buffer film 130 may increase the ferroelectricity of the gate insulating film 120 by applying mechanical stress to the gate insulating film 120. For example, the buffer film 130 may induce the crystal structure of the gate insulating film 120 including hafnium-based oxide to an orthorhombic phase, in an annealing process for the gate insulating film 120.

A buffer oxide film 135 is formed between the gate insulating film 120 and the buffer film 130. The buffer oxide film 135 may include an oxide of the second semiconductor material of the buffer film 130. For example, the buffer oxide film 135 may be an oxide film formed by oxidizing the surface (e.g., a bottom surface) of the buffer film 130 adjacent to the gate insulating film 120. For example, if the buffer film 130 includes silicon (Si), the buffer oxide film 135 may include silicon oxide.

In some embodiments, the buffer oxide film 135 may come into contact with the gate insulating film 120. That is, the buffer oxide film 135 may be formed directly over the gate insulating film 120, and the buffer film 130 may be formed directly over the buffer oxide film 135.

In some embodiments, the thickness T1 of the interface film 105 may be smaller than the thickness T2 of the buffer oxide film 135. Preferably, the thickness T2 of the buffer oxide film 135 may be about 5 Å or more. For example, the thickness T2 of the buffer oxide film 135 may be between about 5 Å and about 15 Å.

In some embodiments, the sum T1+T2 of the thickness T1 of the interface film 105 and the thickness T2 of the buffer oxide film 135 may be about 5 Å to about 15 Å.

The gate electrode film 140 may be stacked on the buffer film 130. The gate electrode film 140 may include a metal element. For example, the gate electrode film 140 may include a metal film or a conductive metal nitride film. For example, the gate electrode film 140 may be include, but is not limited to, at least one of tungsten (W), aluminum (Al), copper (Cu), titanium (Ti), tantalum (Ta), titanium nitride (TiN), tantalum nitride (TaN), tungstate nitride (WN), tungsten carbonitride (WCN), or combinations thereof.

In some embodiments, the coefficient of thermal expansion (CTE) of the gate electrode film 140 may be smaller than the coefficient of thermal expansion (CTE) of the gate insulating film 120. For example, when the gate insulating film 120 includes hafnium-based oxide, the gate electrode film 140 may include at least one of tungsten (W) or titanium nitride (TiN). Such a gate electrode film 140 may increase the ferroelectricity of the gate insulating film 120 by applying mechanical stress to the gate insulating film 120. For example, the gate electrode film 140 may induce a crystal structure of the gate insulating film 120 into an orthorhombic phase, in an annealing process for the gate insulating film 120.

Although the gate electrode film 140 is only shown to be a single film, this is merely an example. Unlike the shown example, the gate electrode film 140 may be formed by stacking a plurality of conductive materials. For example, the gate electrode film 140 may include a work function adjusting film that adjusts the work function, and a filling conductive film that fills a space formed by the work function adjusting film. The work function adjusting film may include, for example, at least one of TiN, TaN, titanium carbide (TiC), tantalum carbide (TaC), titanium aluminum carbide (TiAIC), or combinations thereof. The filling conductive film may include, for example, W or Al.

In some embodiments, the first gate structure GS1 may further include a gate spacer 160. The gate spacer 160 may be on (e.g., may cover) the side faces of the gate electrode film 140. For example, the gate spacer 160 may extend along the side faces of the gate insulating film 120, the side faces of the buffer oxide film 135, the side faces of the buffer film 130, and the side faces of the gate electrode film 140. The gate spacer 160 may include, but is not limited to, an insulating material, for example, at least one of silicon oxide, silicon nitride, silicon oxynitride, or combinations thereof.

A first source/drain region 102 may be formed inside (or on) the substrate 100 on the side faces of the first gate structure GS1. The first source/drain region 102 may be an impurity region formed by implanting impurities into the substrate 100 or may be an epitaxial layer formed on the substrate 100.

A first source/drain region 102 may have a second conductivity type different from the first conductivity type. For example, if the semiconductor device according to some embodiments is an NFET, the first source/drain region 102 may include n-type impurities or impurities for impeding/preventing diffusion of the n-type impurities. For example, the first source/drain regions 102 may include at least one of P, Sb, As, or combinations thereof. Alternatively, for example, if the semiconductor device according to some embodiments is a PFET, the first source/drain regions 102 may include p-type impurities or impurities for impeding/preventing diffusion of p-type impurities. For example, the first source/drain regions 102 may include at least one of B, C, In, Ga, or Al, or combinations thereof.

The substrate 100, the first source/drain region 102 and the first gate structure GS1 described above may form a ferroelectric field effect transistor (FeFET). The region of the substrate 100 that forms the ferroelectric field effect transistor may also be referred to herein as an active region (or an active pattern).

A first interlayer insulating film 180 may be formed on the substrate 100. The first interlayer insulating film 180 may be on (e.g., may cover) the first gate structure GS1 and the first source/drain region 102. The first interlayer insulating film 180 may include, for example, at least one of silicon oxide, silicon nitride, silicon oxynitride, or a low dielectric constant (low-k) material having a lower dielectric constant than silicon oxide. The low dielectric constant material may include, for example, at least one of FOX (Flowable Oxide), TOSZ (Tonen SilaZane), USG (Undoped Silica Glass), BSG (Borosilica Glass), PSG (PhosphoSilica Glass), BPSG (BoroPhosphoSilica Glass), PETEOS (Plasma Enhanced Tetra Ethyl Ortho Silicate), FSG (Fluoride Silicate Glass), CDO (Carbon Doped silicon Oxide), Xerogel, Aerogel, Amorphous Fluorinated Carbon, OSG (Organo Silicate Glass), Parylene, BCB (bis-benzocyclobutenes), SiLK, polyimide, porous polymeric material, or combinations thereof.

A source/drain contact 192 may be electrically connected to the first source/drain region 102. For example, the source/drain contact 192 may penetrate the first interlayer insulating film 180 and be electrically connected to the first source/drain region 102.

The gate contact 194 may be electrically connected to the gate electrode film 140. For example, the gate contact 194 may penetrate the first interlayer insulating film 180 and be electrically connected to the gate electrode film 140.

The source/drain contact 192 and the gate contact 194 may each include, for example, but are not limited to, a conductive material, for example, at least one of a metal, a conductive metal nitride, a conductive metal carbonitride, a conductive metal carbide, a metal silicide, a doped semiconductor material, a conductive metal oxynitride, a conductive metal oxide, or a two-dimensional material (2D material).

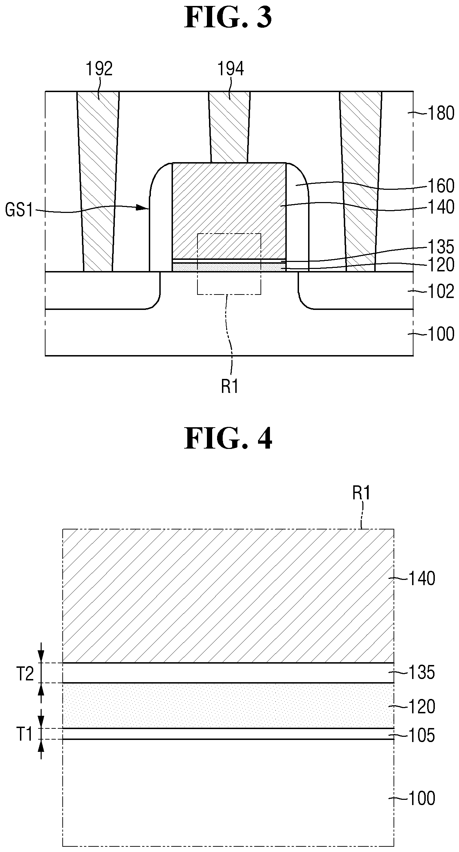

FIG. 3 is an example cross-sectional view for explaining a semiconductor device according to some embodiments. FIG. 4 is an enlarged view for explaining a region R1 of FIG. 3. For convenience of explanation, repeated parts of contents explained above using FIGS. 1 and 2 will be briefly explained or omitted.

Referring to FIGS. 3 and 4, in the semiconductor device according to some embodiments, a first gate structure GS1 may include a gate insulating film 120, a buffer oxide film 135 and a gate electrode film 140 which are sequentially stacked on the substrate 100.

For example, the buffer oxide film 135 may come into contact with the gate electrode film 140. That is, the buffer oxide film 135 may be formed directly over the gate insulating film 120, and the gate electrode film 140 may be formed directly over the buffer oxide film 135. Accordingly, the buffer film 130 described above using FIGS. 1 and 2 may be not interposed (i.e., may be absent) between the buffer oxide film 135 and the gate electrode film 140.

In some embodiments, the interface film 105 may form between the substrate 100 and the gate insulating film 120, as shown in FIG. 4. In some embodiments, a thickness T1 of the interface film 105 may be smaller than the thickness T2 of the buffer oxide film 135.

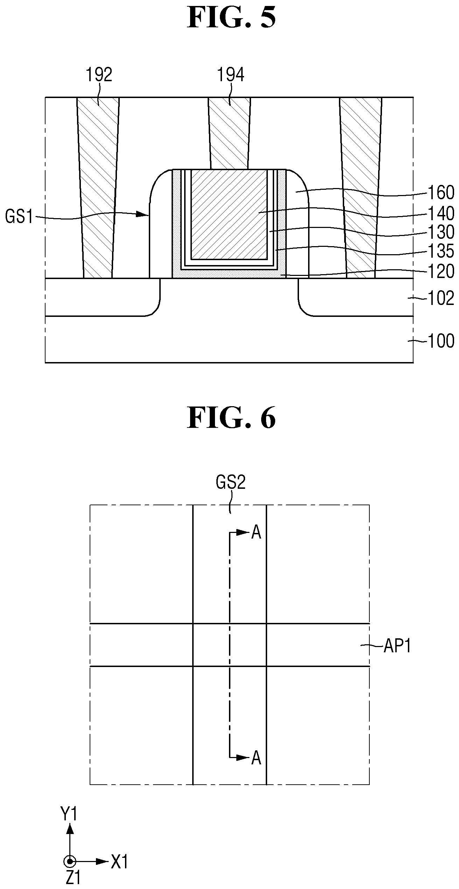

FIG. 5 is an example cross-sectional view for explaining a semiconductor device according to some embodiments. For convenience of explanation, repeated parts of contents explained above using FIGS. 1 and 2 will be briefly explained or omitted.

Referring to FIG. 5, in the semiconductor device according to some embodiments, each of the gate insulating film 120, the buffer oxide film 135 and the buffer film 130 may further extend (e.g., may vertically extend) along the inner side faces of the gate spacer 160.

For example, the gate insulating film 120, the buffer oxide film 135 and the buffer film 130 may conformally extend along the upper side of the substrate 100 and the inner side faces of the gate spacers 160, respectively. The first gate structure GS1 including the gate insulating film 120, the buffer oxide film 135 and the buffer film 130 may be formed by, for example, a replacement process, but is not limited thereto.

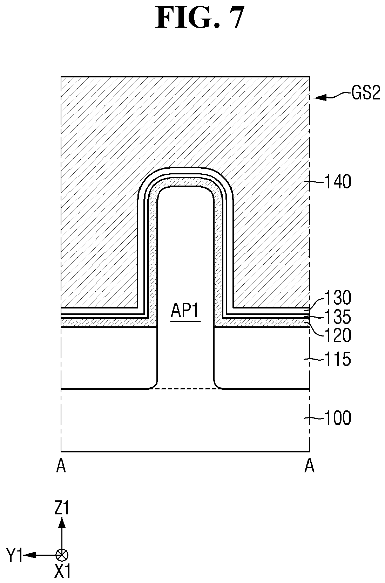

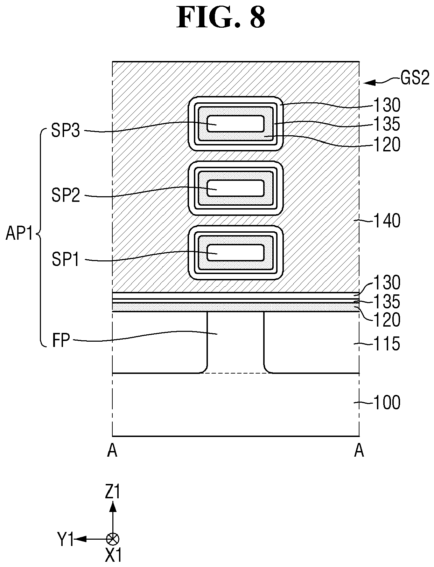

FIG. 6 is an example layout diagram for explaining a semiconductor device according to some embodiments. FIGS. 7 and 8 are various schematic cross-sectional views taken along A-A of FIG. 6. For convenience of explanation, repeated parts of contents explained above using FIGS. 1 to 5 will be briefly explained or omitted.

Referring to FIGS. 6 to 8, a semiconductor device according to some embodiments includes a substrate 100, a first active pattern AP1, a field insulating film 115, and a second gate structure GS2.

The first active pattern AP1 may be formed on the substrate 100. The first active pattern AP1 may extend in a first direction X1 parallel to the upper side (e.g., an upper surface) of the substrate 100. The first active pattern AP1 may be a part of the substrate 100, and may include an epitaxial layer grown from the substrate 100. The first active pattern AP1 may include, for example, silicon or germanium, which is an elemental semiconductor material. Alternatively, the first active pattern AP1 may include a compound semiconductor, for example, a group IV-IV compound semiconductor or a group III-V compound semiconductor.

The field insulating film 115 may be formed on the substrate 100. The field insulating film 115 may be on (e.g., may cover) at least a part of side faces of the first active pattern AP1. The field insulating film 115 may include, for example, but is not limited to, at least one of silicon oxide (SiO₂), silicon oxynitride (SiON), silicon oxycarbonitride (SiOCN), or combinations thereof.

The second gate structure GS2 may be formed on the first active pattern AP1 and the field insulating film 115. Also, the second gate structure GS2 may intersect the first active pattern AP1. For example, the second gate structure GS2 may extend in a second direction Y1 that is parallel to the upper side of the substrate 100 and intersects the first direction X1.

In some embodiments, the second gate structure GS2 may include a gate insulating film 120, a buffer oxide film 135, a buffer film 130 and a gate electrode film 140 which are sequentially stacked on the first active pattern AP1. Therefore, the first active pattern AP1 and the second gate structure GS2 may form a ferroelectric field effect transistor (FeFET) that forms a channel along the first direction X1.

Although not specifically shown, an interface film (105 of FIG. 2) may be formed between the first active pattern AP1 and the gate insulating film 120. Moreover, unlike the shown example, the buffer film 130 may be not interposed between the buffer oxide film 135 and the gate electrode film 140.

Referring to FIGS. 6 and 7, in the semiconductor device according to some embodiments, the first active pattern AP1 may include a fin pattern.

For example, the first active pattern AP1 may protrude from the upper side of the substrate 100 (for example, protrude in a third direction Z1 intersecting the first direction X1 and the second direction Y1) and extend long in the first direction X1. The second gate structure GS2 may extend along three sides (e.g., opposite side faces and the upper side) of the fin-shaped first active pattern AP1. For example, the gate insulating film 120, the buffer oxide film 135, and the buffer film 130 may each conformally extend along opposite side faces and upper side of the first active pattern AP1.

In some embodiments, the gate insulating film 120, the buffer oxide film 135 and the buffer film 130 may further extend along the upper side of the field dielectric film 115.

Referring to FIGS. 6 and 8, in the semiconductor device according to some embodiments, the first active pattern AP1 may include a plurality of sheet patterns.

For example, the first active pattern AP1 may include first to third sheet patterns SP1, SP2, and SP3 arranged along the third direction Z1 and spaced apart from each other. The first to third sheet patterns SP1, SP2 and SP3 may each extend in the first direction X1 and penetrate the second gate structure GS2. For example, the gate insulating film 120, the buffer oxide film 135 and the buffer film 130 may conformally extend along the periphery of each of the first to third sheet patterns SP1, SP2 and SP3.

In some embodiments, the first active pattern AP1 may further include a fin pattern FP that protrudes from the upper side of the substrate 100 and extends in the first direction X1. The first to third sheet patterns SP1, SP2 and SP3 may be arranged in order on the upper side of the pin pattern FP.

In some embodiments, the gate insulating film 120, the buffer oxide film 135 and the buffer film 130 may further extend along the upper side of the fin pattern FP and the upper side of the field insulating film 115.

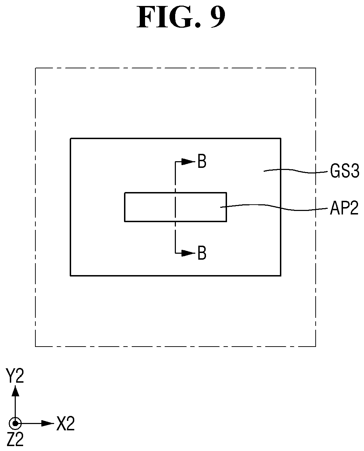

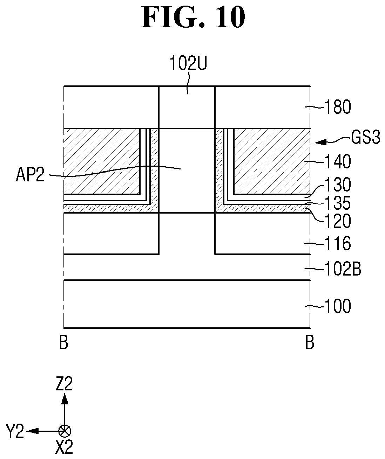

FIG. 9 is an example layout diagram for explaining a semiconductor device according to some embodiments. FIG. 10 is a schematic cross-sectional view taken along B-B of FIG. 9. For convenience of explanation, repeated parts of contents explained above using FIGS. 1 to 5 will be briefly explained or omitted.

Referring to FIGS. 9 and 10, the semiconductor device according to some embodiments includes a substrate 100, a lower source/drain region 102B, a spacer pattern 116, a second active pattern AP2, a third gate structure GS3 and an upper source/drain region 102U.

The lower source/drain region 102B may be formed on the substrate 100. The lower source/drain region 102B may be an impurity region formed by implanting impurities into the substrate 100, or may be an epitaxial layer formed on the substrate 100.

The lower source/drain region 102B may have the second conductivity type. For example, if the semiconductor device according to some embodiments is an NFET, the lower source/drain region 102B may include n-type impurities or impurities for impeding/preventing diffusion of the n-type impurities. Alternatively, for example, if the semiconductor device according to some embodiments is a PFET, the lower source/drain regions 102B may include p-type impurities or impurities for impeding/preventing diffusion of the p-type impurities.

The spacer pattern 116 may cover a first portion of the lower source/drain region 102B. Other parts of the lower source/drain regions 102B may be exposed by the spacer pattern 116. A second portion of the lower source/drain region 102B exposed from the spacer pattern 116 may include, but is not limited to, a long side extending in a fourth direction X2 and a short side extending in a fifth direction Y2. Although the upper side of the spacer pattern 116 is only shown as being coplanar with the upper side of the lower source/drain region 102B, this is merely an example. The spacer pattern 116 may include an insulating material, for example, but is not limited to, at least one of silicon oxide, silicon nitride, silicon oxynitride, or combinations thereof.

A second active pattern AP2 may be formed on the lower source/drain region 102B. For example, the second active pattern AP2 may be electrically connected to the upper side of the lower source/drain region 102B. The second active pattern AP2 may extend from the portion of the lower source/drain region 102B exposed from the spacer pattern 116 in a sixth direction Z2 that intersects the fourth direction X2 and the fifth direction Y2.

A third gate structure GS3 may be formed on the spacer pattern 116. Also, the third gate structure GS3 may be formed on the side face of the second active pattern AP2. For example, the third gate structure GS3 may surround the side faces of the second active pattern AP2.

An upper source/drain region 102U may be formed on the second active pattern AP2. For example, the upper source/drain region 102U may be electrically connected to the upper side of the second active pattern AP2. That is, the second active pattern AP2 may be interposed between the lower source/drain region 102B and the upper source/drain region 102U.

The upper source/drain region 102U may have a second conductivity type. For example, if the semiconductor device according to some embodiments is an NFET, the upper source/drain region 102U may include n-type impurities or impurities for impeding/preventing diffusion of the n-type impurities. Alternatively, for example, if the semiconductor device according to some embodiments is a PFET, the upper source/drain region 102U may include p-type impurities or impurities for impeding/preventing diffusion of the p-type impurities.

In some embodiments, the third gate structure GS3 may include a gate insulating film 120, a buffer oxide film 135, a buffer film 130, and a gate electrode film 140 which are sequentially stacked on side faces of the second active pattern AP2. Accordingly, the second active pattern AP2, the second gate structure GS2, the lower source/drain region 102B, and the upper source/drain region 102U may form a ferroelectric field effect transistor (FeFET) which forms a channel along the sixth direction Z2. In some embodiments, the gate insulating film 120, the buffer film 130, the buffer oxide film 135 and the gate electrode film 140 may further extend along the upper side of the spacer pattern 116.

Although not specifically shown, an interface film (e.g., the film 105 of FIG. 2) may form between the second active pattern AP2 and the gate insulating film 120. Moreover, unlike the shown example, the buffer film 130 may be not interposed between the buffer oxide film 135 and the gate electrode film 140.

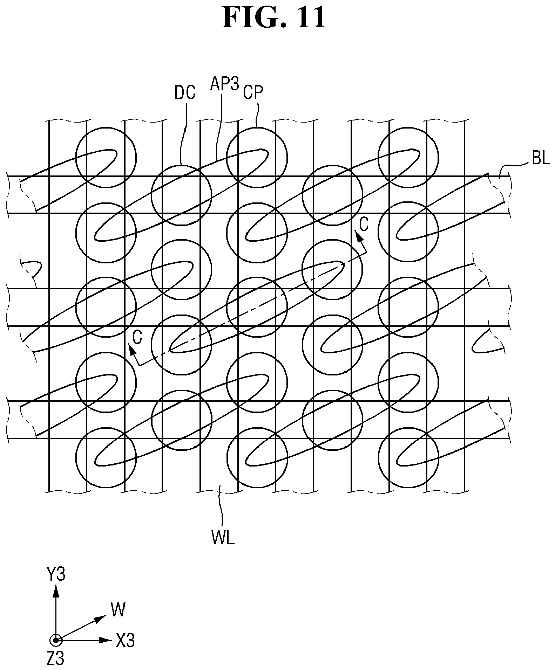

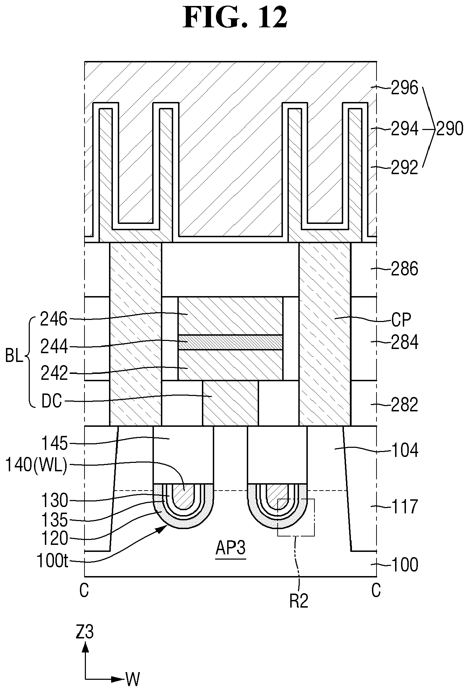

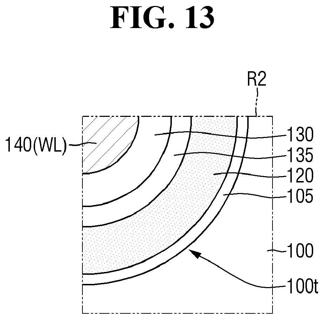

FIG. 11 is an example layout diagram for explaining a semiconductor device according to some embodiments. FIG. 12 is a schematic cross-sectional view taken along C-C of FIG. 11. FIG. 13 is an enlarged view for explaining a region R2 of FIG. 12. For convenience of explanation, repeated parts of contents explained above using FIGS. 1 to 5 will be briefly explained or omitted.

Referring to FIGS. 11 to 13, a semiconductor device according to some embodiments includes a substrate 100, an element isolation film 117, second source/drain regions 104, a word line WL, a bit line BL, a bit line contact DC, a capacitor structure 290 and a capacitor contact CP.

The element isolation film 117 may define a plurality of third active patterns AP3 inside the substrate 100. The element isolation film 117 may include, but is not limited to, an insulating material, for example, at least one of silicon oxide, silicon nitride, silicon oxynitride, or combinations thereof.

A third active pattern AP3 may extend in a seventh direction W inside the substrate 100. The third active pattern AP3 may be in the form of a plurality of bars extending in directions parallel to each other. In some embodiments, a central portion of one third active pattern AP3 may be placed to be adjacent to a distal end portion of another (e.g., an adjacent) third active pattern AP3.

Second source/drain regions 104 may be formed inside the third active pattern AP3. The second source/drain regions 104 may be impurity regions formed by implanting impurities into the substrate 100 or epitaxial layers formed on the substrate 100. The second source/drain regions 104 may have a second conductivity type.

The word line WL may be formed on the substrate 100 and the element isolation film 117. The word line WL may extend long in an eighth direction X3 different from the seventh direction W. Also, the word line WL may intersect the third active pattern AP3 between the bit line contact DC and the capacitor contact CP. For example, the word line WL may intersect the third active pattern AP3 obliquely and may intersect the bit line BL vertically. A plurality of word lines WL extends parallel to each other and may be spaced apart from each other at equal intervals.

In some embodiments, the word line WL may correspond to the gate electrode film 140 described above using FIGS. 1 and 2. For example, the gate insulating film 120, the buffer oxide film 135 and the buffer film 130 may be interposed between the third active pattern AP3 and the word line WL. The gate insulating film 120, the buffer oxide film 135 and the buffer film 130 may be sequentially stacked on the third active pattern AP3.

As shown in FIG. 13, an interface film (e.g., film 105 of FIG. 2) may form between the third active pattern AP3 and the gate insulating film 120. Moreover, unlike the shown example, the buffer film 130 need not be interposed between the buffer oxide film 135 and the gate electrode film 140.

In some embodiments, the word line WL may be embedded inside the substrate 100. For example, the substrate 100 may include a gate trench 100t extending in the eighth direction X3. The gate insulating film 120, the buffer oxide film 135 and the buffer film 130 may extend along the profile of the gate trench 100t. The gate electrode film 140 (or the word line WL) may fill at least a part of the gate trench 100t on the buffer film 130 (or the buffer oxide film 135). Accordingly, the third active pattern AP3, the word line WL and the second source/drain regions 104 may form a ferroelectric field effect transistor (FeFET) including a channel formed along the profile of the gate trench 100t.

In some embodiments, a capping pattern 145 may be formed on the gate electrode film 140 (or the word line WL). The capping pattern 145 may extend along the upper side of the gate electrode film 140. For example, the capping pattern 145 may fill another part of the gate trench 100t above the gate electrode film 140. In this case, the upper side of the gate electrode film 140 may be formed to be lower than the upper side of the third active pattern AP3. The capping pattern 145 may include, but is not limited to, an insulating material, for example, at least one of silicon oxide, silicon nitride, silicon oxynitride, or combinations thereof.

The bit line BL may be formed on the substrate 100 and the element isolation film 117. For example, a second interlayer insulating film 282 that covers the substrate 100, the element isolation film 117 and the capping pattern 145 may be formed. The bit line BL may be formed on the second interlayer insulating film 282. The bit line BL may extend long in a tenth direction Z3 different from the seventh direction W and the eighth direction X3. For example, the bit line BL may intersect the third active pattern AP3 obliquely and intersect the word line WL vertically. A plurality of bit lines BL extends parallel to each other and may be spaced apart from each other at equal intervals.

In some embodiments, the bit line BL may include a first conductive line 242, a second conductive line 244, and a third conductive line 246 that are sequentially stacked on the third active pattern AP3. The first conductive line 242, the second conductive line 244, and the third conductive line 246 may each include, but are not limited to, a conductive material, for example, at least one of polysilicon, TiN, titanium silicon nitride (TiSiN), tungsten, tungsten silicide, or combinations thereof. In an example, the first conductive line 242 may include polysilicon, the first conductive line 244 may include TiSiN, and the third conductive line 246 may include tungsten.

A bit line contact DC may electrically connect the third active pattern AP3 and the bit line BL. For example, the bit line contact DC may penetrate the second interlayer insulating film 282 and electrically connect the third active pattern AP3 and the bit line BL. In some embodiments, the bit line contact DC may be electrically connected to the central portion (e.g., a center point) of the third active pattern AP3.

A capacitor structure 290 may be formed on the substrate 100 and the element isolation film 117. For example, a third interlayer insulating film 284 and a fourth interlayer insulating film 286 that are stacked sequentially on the second interlayer insulating film 282 may be formed. The capacitor structure 290 may be formed on the fourth interlayer insulating film 286.

The capacitor structure 290 may be controlled by the word line WL and the bit line BL to store data. For example, the capacitor structure 290 may include a lower electrode 292, a capacitor dielectric film 294 and an upper electrode 296 that are sequentially stacked on the fourth interlayer insulating film 286. The capacitor structure 290 may store charges (i.e., data) in the capacitor dielectric film 294, using a potential difference generated between the lower electrode 292 and the upper electrode 296.

The lower electrode 292 and the upper electrode 296 may include, for example, but are not limited to, doped polysilicon, metal or metal nitride. In addition, the capacitor dielectric film 294 may include, for example, but is not limited to, silicon oxide or a high dielectric constant material.

The capacitor contact CP may electrically connect the third active pattern AP3 and the capacitor structure 290. For example, the capacitor contact CP penetrates the second interlayer insulating film 282, the third interlayer insulating film 284, and the fourth interlayer insulating film 286, and may electrically connect the third active pattern AP3 and the lower electrode 292. In some embodiments, the capacitor contact CP may be electrically connected to opposite end portions of the third active pattern AP3.

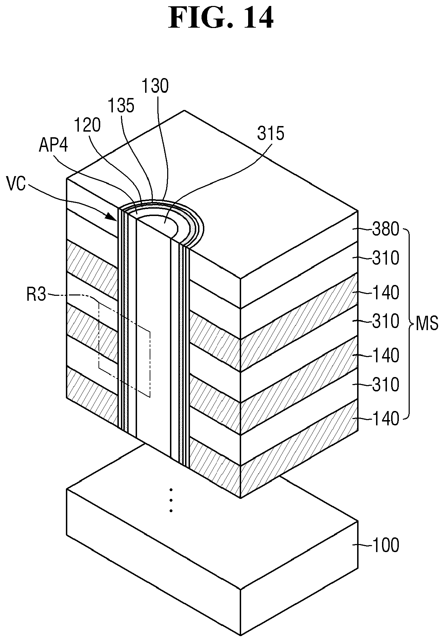

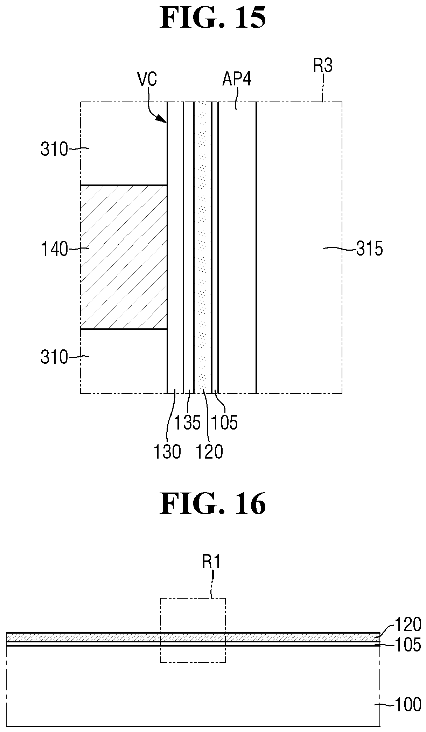

FIG. 14 is an example perspective view for explaining a semiconductor device according to some embodiments. FIG. 15 is an enlarged view for explaining a region R3 of FIG. 14. For convenience of explanation, repeated parts of contents explained above using FIGS. 1 to 5 will be briefly explained or omitted.

Referring to FIGS. 14 and 15, a semiconductor device according to some embodiments includes a substrate 100, a mold structure MS and a vertical structure VC.

The mold structure MS may include a plurality of mold insulating films 310 and a plurality of gate electrode films 140 that are alternately stacked on the substrate 100. The mold insulating film 310 and the gate electrode film 140 may each have a layered structure extending parallel to the upper side of the substrate 100. The gate electrode films 140 are spaced apart from each other by the mold insulating film 310 and may be sequentially stacked on the substrate 100.

The mold insulating film 310 may include, but is not limited to, an insulating material, for example, at least one of silicon oxide, silicon nitride, or silicon oxynitride. For example, the mold insulating film 310 may include a silicon oxide film.

A vertical structure VC may be formed on the substrate 100. The vertical structure VC may extend in a direction (e.g., a vertical direction) intersecting the upper side of the substrate 100 and penetrate the mold structure MS. As an example, the vertical structure VC may be a vertically extending pillar-shaped (e.g., cylindrical) structure.

The vertical structure VC may include a fourth active pattern AP4. The fourth active pattern AP4 may extend vertically and intersect the plurality of gate electrode films 140. For example, the fourth active pattern AP4 may have various shapes such as a cup shape, a cylindrical shape, a square barrel shape, and a hollow filler shape. The fourth active pattern AP4 may include, for example, but is not limited to, semiconductor materials such as monocrystalline silicon, polycrystalline silicon, organic semiconductor, and carbon nanostructure.

In some embodiments, a gate insulating film 120, a buffer oxide film 135 and a buffer film 130 may be interposed between the fourth active pattern AP4 and the gate electrode film 140. The gate insulating film 120, the buffer oxide film 135 and the buffer film 130 may be sequentially stacked on the outer side faces of the fourth active pattern AP4. Therefore, the fourth active pattern AP4 and the gate electrode film 140 may form a plurality of ferroelectric field effect transistors (FeFET) arranged along the vertical direction.

As shown in FIG. 15, the interface film (e.g., film 105 of FIG. 2) may form between the fourth active pattern AP4 and the gate insulating film 120. Moreover, unlike the shown example, the buffer film 130 need not be interposed between the buffer oxide film 135 and the gate electrode film 140.

In some embodiments, the vertical structure VC may further include a filling pattern 315. The filling pattern 315 may be formed, for example, to fill the inside of the cup-shaped fourth active pattern AP4. The filling pattern 315 may include, but is not limited to, an insulating material such as silicon oxide.

A method for fabricating a semiconductor device according to example embodiments now be described below referring to FIGS. 16 to 22.

FIGS. 16 to 20 are intermediate process diagrams for explaining the method for fabricating the semiconductor device according to some embodiments. For convenience of explanation, repeated parts of contents explained above using FIGS. 1 to 15 will be briefly explained or omitted.

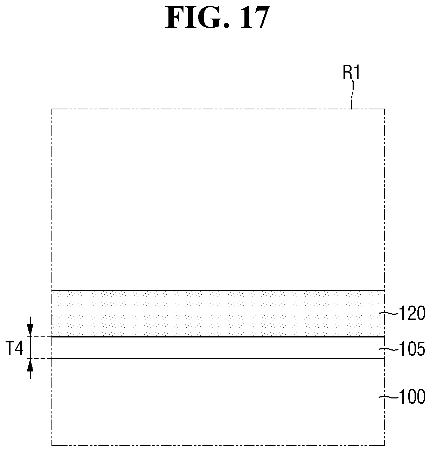

Referring to FIGS. 16 and 17, the gate insulating film 120 is formed on the substrate 100. For reference, FIG. 17 is an enlarged view for explaining the region R1 of FIG. 16.

The substrate 100 may include a first semiconductor material. In an example, the first semiconductor material may be silicon (Si). In some embodiments, the substrate 100 may include the first semiconductor material doped with impurity elements of the first conductivity type.

The gate insulating film 120 may be deposited by, for example, but is not limited to, an atomic layer deposition (ALD) type of deposition. The gate insulating film 120 may include a ferroelectric material having hysteresis characteristics. In some embodiments, the gate insulating film 120 may include a hafnium-based oxide having ferroelectricity.

As the gate insulating film 120 is formed on the substrate 100, the interface film 105 may form between the substrate 100 and the gate insulating film 120. The interface film 105 may be a natural oxide film formed by oxidation of the surface (e.g., the upper side) of the substrate 100 adjacent to the gate insulating film 120. For example, the interface film 105 may form by diffusion of oxygen atoms contained in the gate insulating film 120 into the substrate 100. A thickness T4 of the interface film 105 may be, for example, about 5 Å to about 15 Å.

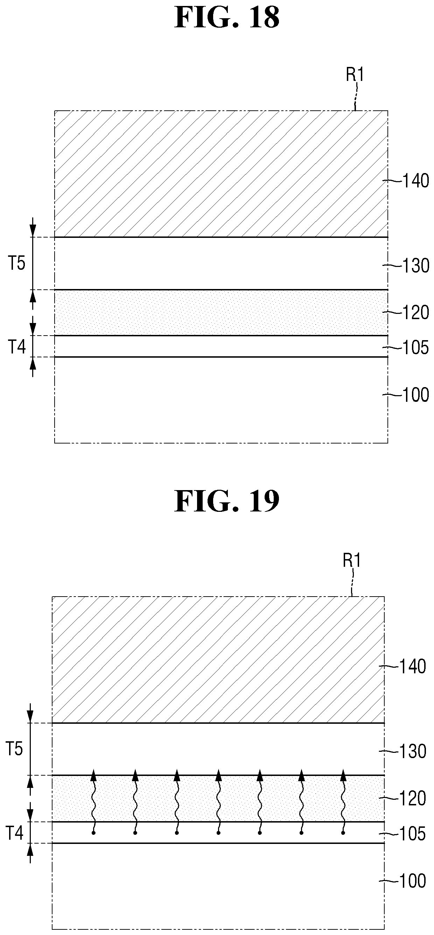

Referring to FIG. 18, the buffer film 130 and the gate electrode film 140 are sequentially formed on the gate insulating film 120.

The buffer film 130 may be stacked on the gate insulating film 120. In some embodiments, the buffer film 130 may be stacked directly over the gate insulating film 120. The buffer film 130 may include a second semiconductor material. In an example, the second semiconductor material may be silicon (Si). In some embodiments, the first semiconductor material and the second semiconductor material may be the same as each other.

A thickness T5 of the buffer film 130 may be smaller than about 10 nm. The buffer film 130 may impede/prevent deterioration of the characteristics of the semiconductor device within the above range. Preferably, the thickness T5 of the buffer film 130 may be about 5 nm or less. For example, the thickness T5 of the buffer film 130 may be between approximately 0.01 nm and approximately 5 nm. More preferably, the thickness T3 of the buffer film 130 may be about 1 nm or less.

The gate electrode film 140 may be stacked on the buffer film 130. In some embodiments, the gate electrode film 140 may be stacked directly over the buffer film 130. The gate electrode film 140 may include a metal element. For example, the gate electrode film 140 may include a metal film or a conductive metal nitride film.

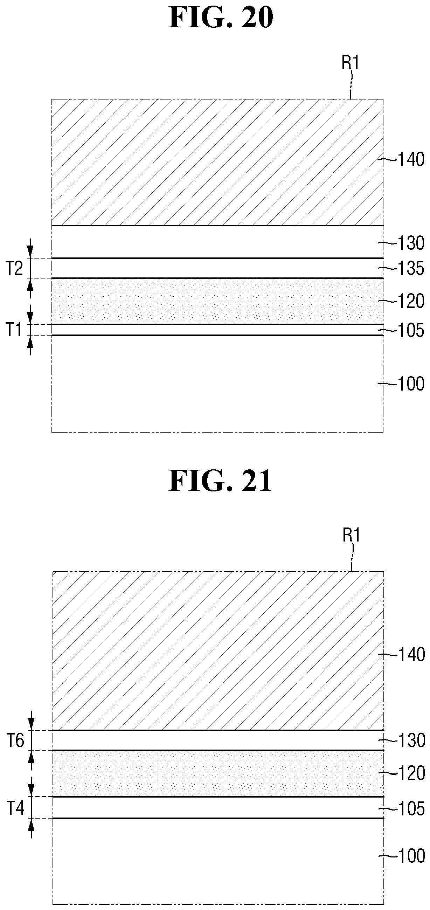

Referring to FIGS. 19 and 20, an annealing process is performed. Therefore, the semiconductor device described above using FIGS. 1 and 2 may be fabricated.

The annealing process may include, for example, but is not limited to, an RTA (Rapid Thermal Annealing) process. As the annealing process is performed, the interface film 105 may be thinned or removed. Specifically, oxygen atoms contained in the interface film 105 may move to the buffer film 130 through the gate insulating film 120 in the annealing process. Oxygen atoms moved to the buffer film 130 may form a buffer oxide film 135 between the gate insulating film 120 and the buffer film 130.

This may be understood as equilibrium of oxygen atoms formed between the interface film 105 and the buffer film 130 through the gate insulating film 120. As an example, since the hafnium atoms contained in the gate insulating film 120 have a higher coordination number than the silicon atoms contained in the interface film 105, the hafnium atoms on the surface of the gate insulating film 120 adjacent to the interface film 105 may be additionally bonded to oxygen atoms. Additionally bounded oxygen atoms establish equilibrium with the oxygen atoms forming the crystal structure in the gate insulating film 120, and may be transported toward the buffer film 130 having a relatively low concentration of oxygen atoms. That is, due to the presence of the buffer film 130, at least a part of the interface film 105 may disappear in the annealing process.

The reduced thickness T1 of the interface film 105 may be smaller than about 1 nm. Preferably, the thickness T1 of the interface film 105 may be about 5 Å or less. The characteristics of the ferroelectric field effect transistor (FeFET) including the gate insulating film 120 may be improved within the above range. For example, the thickness T1 of the interface film 105 may be controlled from about 0.01 Å to about 5 Å, as the process variables of the annealing process are adjusted. More preferably, the thickness T1 of the interface film 105 may be about 1 Å or less.

In some embodiments, the reduced thickness T1 of the interface film 105 may be smaller than the thickness T2 of the buffer oxide film 135. For example, as the substrate 100 contains an impurity element, the reduced thickness T1 of the interface film 105 may be smaller than the thickness T2 of the buffer oxide film 135 to be formed. In some embodiments, the sum T1 +T2 of the thickness T1 of the interface film 105 and the thickness T2 of the buffer oxide film 135 may be about 5 Å to about 15 Å.

In some other embodiments, the interface film 105 may be not present between the substrate 100 and the gate insulating film 120. Here, the absence of the interface film 105 means not only a case where the interface film 105 does not exist at all between the substrate 100 and the gate insulating film 120, but also a case where the interface film 105 exists very slightly at a thickness below the limit of measurement using transmission electron microscope (TEM) image analysis or the like. For example, the interface film 105 may disappear completely, as the process variables of the annealing process are adjusted.

In some embodiments, the ferroelectricity of the gate insulating film 120 may be enhanced as the annealing process is performed. For example, the buffer film 130 and the gate electrode film 140 may induce the crystal structure of the gate insulating film 120 containing hafnium-based oxide to an orthorhombic phase, by applying a mechanical stress to the gate insulating film 120 in the annealing process.

Research for improving the performance by applying the characteristics of ferroelectrics to the semiconductor device is being conducted. In particular, with the discovery of the ferroelectricity of hafnium-based oxides, the ferroelectric field effect transistor (FeFET) that uses hafnium-based oxide as the gate insulating film is being developed. Because hafnium-based oxide is friendly (i.e., conducive) to the semiconductor processes and may maintain ferroelectricity even in very thin films, it is expected to contribute to the miniaturization of the semiconductor device.

However, the interface film naturally generated in the process of forming the gate insulating film may cause deterioration of the characteristics of the ferroelectric field effect transistor (FeFET). For example, in the process of depositing the gate insulating film 120 including hafnium-based oxide, oxygen atoms contained in the gate insulating film 120 may diffuse into the substrate 100 to form the interface film 105 of about 1 nm between the substrate 100 and the gate insulating film 120. Such an interface film 105 may cause charge trapping, breakdown, and the like, and may deteriorate the characteristics of the semiconductor device including the ferroelectric field effect transistor (FeFET), for example, endurance (e.g., program/erase cycling endurance) and memory window, and the like.

In contrast, the semiconductor device according to some embodiments may have improved characteristics by eliminating at least a part of the interface film 105. Specifically, as described above, at least part of the interface film 105 formed between the substrate 100 and the gate insulating film 120 may disappear due to the presence of the buffer film 130 formed on the gate insulating film 120 (for example, the interface film 105 may be controlled to a thickness of about 5 Å or less, or may be eliminated to a thickness below the limit of measurement using the transmission electron microscopy (TEM) image analysis). Accordingly, it is possible to provide a semiconductor device including a ferroelectric field effect transistor (FeFET) in which characteristics such as endurance and memory window are improved, and a method for fabricating the same.

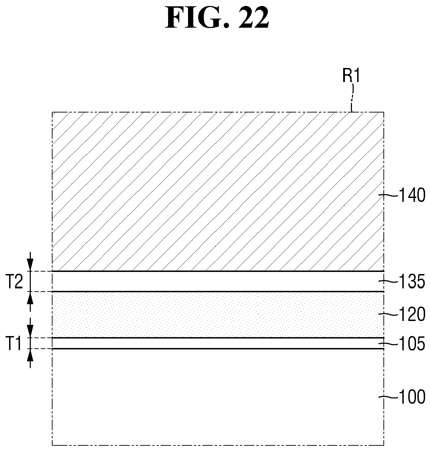

FIGS. 21 and 22 are intermediate step diagrams for describing a method for fabricating the semiconductor device according to some embodiments. For convenience of explanation, repeated parts of contents explained above using FIGS. 1 to 20 will be briefly explained or omitted. For reference, FIG. 21 is an intermediate step diagram for explaining the steps after FIG. 17.

Referring to FIG. 21, the buffer film 130 and the gate electrode film 140 are sequentially formed on the gate insulating film 120. Since the formation of the buffer film 130 and the gate electrode film 140 may be similar to that described above using FIG. 18, detailed descriptions thereof will not be provided below.

In some embodiments, a thickness T6 of the buffer film 130 may be formed to be relatively thin, to approximately 15 Å or less. For example, the thickness T6 of the buffer film 130 may be about 1 Å to about 15 Å. Preferably, the thickness T6 of the buffer film 130 may be about 1 Å to about 10 Å.

Referring to FIG. 22, an annealing process is performed. Therefore, the semiconductor device described above using FIGS. 3 and 4 may be fabricated. Since performing of the annealing process may be similar to that described above using FIGS. 19 and 20, detailed description thereof will not be provided below.

As the annealing process is performed, the interface film 105 may be thinned or removed. Also, the buffer oxide film 135 is formed between the gate insulating film 120 and the gate electrode film 140. For example, as the buffer film 130 of FIG. 21 is formed relatively thin, the entire buffer film 130 may be oxidized to form the buffer oxide film 135. In this case, the buffer film 130 may be not interposed between the buffer oxide film 135 and the gate electrode film 140.

While the present inventive concept has been particularly shown and described with reference to example embodiments thereof, it will be understood by those of ordinary skill in the art that various changes in form and details may be made therein without departing from the scope of the present inventive concept as defined by the following claims. It is therefore desired that the present embodiments be considered in all respects as illustrative and not restrictive, reference being made to the appended claims rather than the foregoing description to indicate the scope of the invention.

## Claims

1. A semiconductor device comprising:
a substrate including a first semiconductor material;
a gate electrode film including a metal element, on the substrate;
a gate insulating film including a ferroelectric material between the substrate and the gate electrode film; and
a buffer oxide film including an oxide of a semiconductor material between the gate insulating film and the gate electrode film, the buffer oxide film being in contact with the gate insulating film and/or an interface film including an oxide of the first semiconductor material, between the gate insulating film and the substrate has a thickness smaller than a thickness of the buffer oxide film.

2. The semiconductor device of claim 1, wherein the gate insulating film includes hafnium-based oxide having ferroelectricity.

3. The semiconductor device of claim 1 or 2, wherein the gate electrode film includes:
tungsten;
titanium nitride; or
tungsten and titanium nitride.

4. The semiconductor device of claim 1, 2, or 3, wherein the substrate includes silicon (Si), and the buffer oxide film includes an Si oxide film.

5. The semiconductor device of claim 4, further comprising:
a buffer film including Si, between the buffer oxide film and the gate electrode film.

6. The semiconductor device of any one of claims 1 to 5, further comprising:
an interface film between the substrate and the gate insulating film,
wherein the interface film includes an oxide of a semiconductor material included in the substrate.

7. The semiconductor device of claim 6, wherein the substrate includes silicon (Si), and the interface film includes an Si oxide film.

8. The semiconductor device of any one of claims 1 to 7, comprising
the interface film, and wherein the buffer oxide film includes an oxide of a second semiconductor material.

9. The semiconductor device of claim 8, wherein the buffer oxide film is in contact with the gate insulating film.

10. The semiconductor device of claim 8 or 9, wherein the thickness of the buffer oxide film is 5 angstroms (Å) to 15 Å.

11. The semiconductor device of claim 8, 9 or 10, wherein the thickness of the interface film is 5 angstroms (Å) or less.

12. The semiconductor device of claim 11, wherein the thickness of the interface film is 1 Å or less.

13. The semiconductor device of any one of claims 8 to 12, wherein the gate electrode film is in contact with the buffer oxide film.

14. A method for fabricating a semiconductor device, the method comprising providing a substrate including a first semiconductor material, forming a gate insulating film including a ferroelectric material, on the substrate, forming a buffer film including a second semiconductor material, on the gate insulating film, forming a gate electrode film including a metal element, on the buffer film, and performing an annealing process.

15. The method of claim 14, wherein as the annealing process is performed a thickness of an interface film formed between the substrate and the gate insulating film is reduced, and a buffer oxide film is formed between the gate insulating film and the buffer film.
